# EUROPÄISCHE PATENTANMELDUNG

(11) **EP 1 352 988 A1**
(43) Veröffentlichungstag der Anmeldung: **15.10.2003**
(21) Anmeldenummer: 02008044.6
(22) Anmeldetag: 10.04.2002
(51) Int. Cl.: C23C 16/04, C23C 8/04, C23C 10/04, C23C 4/00

(54) **Verfahren zur Beschichtung eines Bauteils**

(71) Anmelder: SIEMENS AKTIENGESELLSCHAFT, 80333 München (DE)
(72) Erfinder: Berndt, Thomas, 12524 Berlin (DE); Cox, Nigel-Philip, 10119 Berlin (DE); Griep, Andreas, 16356 Ahrensfelde (DE); Kern, Guido, 13158 Berlin (DE); Reich, Gerhard, 10717 Berlin (DE); Reiche, Ralph, 13465 Berlin (DE)

(57) **Zusammenfassung**

Beschichtungen, die auf ein Bauteil aufgebracht werden, müssen in bestimmten Bereichen in aufwändiger Art und Weise wieder entfernt werden, weil dort keine Beschichtung erwünscht war. Bei der nachfolgenden Entfernung dieser Schicht kommt es zu einer Beeinträchtigung des Bauteils beispielsweise in seiner Geometrie.

Das erfindungsgemäße Verfahren zur Beschichtung eines Bauteils (1) weist eine Maskierung (7) auf, die zumindest teilweise aus einem Keramikpulver besteht und so nach der Beschichtung des Bauteils (1) leicht entfernt werden kann.

## Beschreibung

Die Erfindung betrifft ein Verfahren zur Beschichtung eines Bauteils gemäß dem Gattungsbegriff des Anspruchs 1.

Bei der Beschichtung von Bauteilen soll nicht immer die gesamte äußere oder innere Oberfläche eines Bauteils beschichtet werden. Dies gilt für sämtliche Beschichtungsverfahren, wie z.B. Plasmaspritzen, PVD-(physical vapour deposition) oder CVD- (chemical vapour deposition) Prozesse.

Teile der Beschichtung müssen dort entfernt werden, in denen 9keine Beschichtung erwünscht war. Dies geschieht oft durch eine abrasive Abtragung der Beschichtung in diesen Bereichen, da das Material der Beschichtung sehr gut auf dem Bauteil haftet oder sogar mit diesem reagiert, wenn z.B. das Bauteil mit Aluminium beschichtet wurde, um eine Alitierung durchzuführen.
Die abrasive Abtragung führt jedoch zu einer Schädigung oder Geometrieveränderung des Bauteils. Dies ist z.B. beim Sandstrahlen der Fall, bei dem die Sandpartikel bspw. das Aluminium von dem Bauteil wieder entfernen.

Die US-PS 6,036,995 zeigt die Notwendigkeit von Maskierungen durch Klebebänder, Metallfolien. Die Beschichtung erfolgt durch Auftrag von Schlicker. Metallfolien haften nicht gut auf einer Unterlagen und bieten daher unzureichenden Schutz in einer Bedampfungsanlage, in der die aufzutragenden Teilchen sich in allen Richtungen bewegen.
Klebebänder halten keine hohen Temperaturen aus.

Bei der US-PS 5,985,368 erfolgt eine Beschichtung durch einen Schlicker aus Keramik. Es findet keine Maskierung statt.

Die US-PS 6,283,714 zeigt die Notwendigkeit von Maskierungen bei Beschichtungen mit Aluminium. Durch eine bestimmte Anordnung innerhalb der Beschichtungsanlage wird aber vermieden, dass sich Aluminium auf den ungewünschten Stellen abscheidet.

Es ist daher Aufgabe der Erfindung ein Verfahren zur Beschichtung eines Bauteils aufzuzeigen, bei dem durch eine Maskierung eine Beschichtung in den unerwünschten Bereichen unterbleibt, wobei die Maskierung auf einfache Art und Weise entfernt werden kann.

Die Aufgabe wird durch ein Verfahren gemäß Anspruch 1 gelöst. Dabei wird die Oberfläche, in den Bereichen in denen keine Beschichtung erwünscht ist, zumindest teilweise durch ein Keramikpulver geschützt.

In den Unteransprüchen sind weitere vorteilhafte Verbesserungen des Verfahrens gemäß Anspruch 1 aufgelistet.

Ausführungsbeispiele sind in den nachfolgenden Figuren erläutert.

Es zeigen
Figur 1, 2, 3 die Verfahrensschritte gemäß des erfindungsgemäßen Verfahrens,
Figur 4, 5 weitere Ausführungsbeispiele für die Anwendung des erfindungsgemäßen Verfahrens,

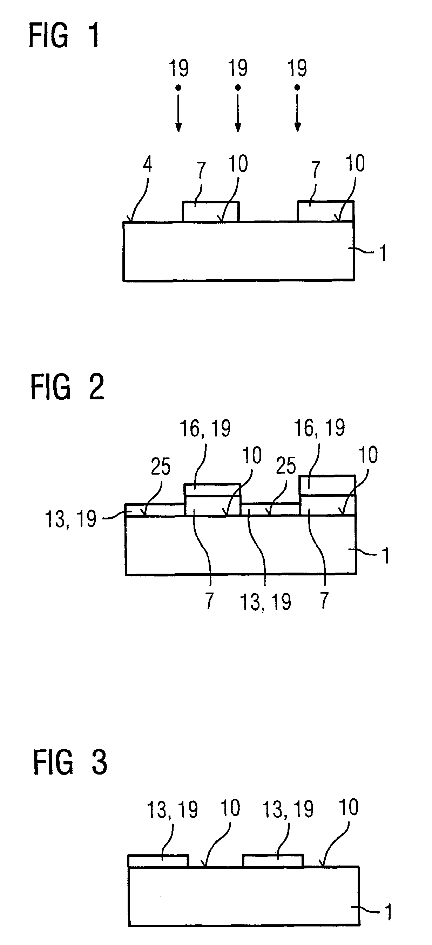

Figur 1 zeigt ein Bauteil 1, insbesondere eine Turbinenschaufel einer Gasturbine, bspw. bestehend aus einer Nickel- oder Cobalt- basierten Superlegierung, das eine Oberfläche 4 aufweist.

Die Oberfläche 4 des Bauteils 1 soll mit einem keramischen oder metallischen Beschichtungsmaterial 19, wie z.B. Aluminium, beschichtet werden.
Dabei gibt es Bereiche 10, in denen eine Beschichtung mit dem Beschichtungsmaterial 19 nicht erwünscht ist, wie z.B. ein Schaufelfuss (Befestigungsbereich) einer Turbinenschaufel.

Diese Bereiche 10 werden durch eine Maskierung 7 geschützt. Die Maskierung 7 besteht aus einer Suspension, einem Schlicker oder einer Paste eines Keramikpulvers, insbesondere Zirkoniumoxid, die durch Eintauchen des Bauteils in die Suspension, Bepinseln, Aufsprühen oder sonstige Auftragungsarten auf das Bauteil 1 aufgebracht wird.
Die Auftragung kann lokal oder auch grossflächig erfolgen. Die Maskierung 7 reagiert nicht mit dem Bauteil 1. Die Maskierung 7 bleibt während der Beschichtung des Bauteils 1 auf dem Bauteil 1 bspw. durch das Vorhandensein eines organischen Binders in der Paste oder der Suspension haften.

Die Beschichtung des Bauteils 1 mit dem Beschichtungsmaterial 19 erfolgt durch einen CVD-Prozess (Chemical vapour deposition) oder PVD-Prozess (phyiscal vapour deposition) oder Plasmaspritzen. Weitere Beschichtungsarten sind denkbar.

Figur 2 zeigt das Bauteil 1, das beschichtet worden ist.
Es gibt Bereiche 25 auf der Oberfläche 4 mit einer Beschichtung 13 auf dem Bauteil 1, wo diese erwünscht ist. Ebenso gibt es eine Beschichtung 16 auf der Maskierung 7.

Da die Maskierung 7 einfach entfernt werden kann, weil sie bspw. nur durch den organischen Binder an dem Bauteil 1 haftet, kommt es in den Bereichen 10, in denen keine Beschichtung erwünscht war, auch zu keiner Beeinträchtigung des Bauteils 1 (Fig. 3).

Die Maskierung 7 kann bspw. durch Abwaschen oder Trockeneisstrahlen entfernt werden.

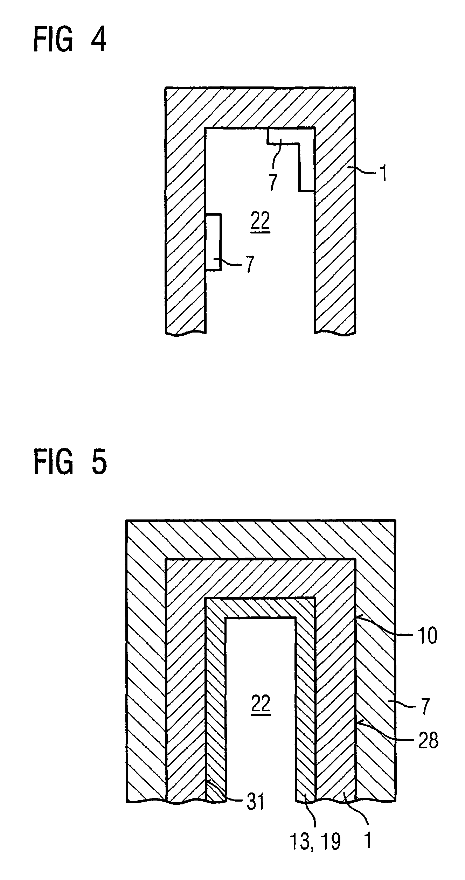

Figur 4 zeigt ein weiteres Anwendungsbeispiel für das erfindungsgemäße Verfahren.
Das Bauteil 1 kann auch einen Hohlraum 22 aufweisen, in dem eine Maskierung 7 aufgebracht wird. Das Verfahren eignet sich also auch für aussenliegende und innenliegende Flächen.

Figur 5 zeigt ein weiteres Anwendungsbeispiel für das erfindungsgemäße Verfahren.
Bei dem Bauteil 1 soll eine Beschichtung 13 im Hohlraum 22 des Bauteils 1 erfolgen.
Eine Beschichtung einer äusseren Oberfläche 28 des Bauteils 1 ist nicht erwünscht, so dass eine Maskierung 7 auf die aussenliegende Fläche 28 des Bauteils 1 aufgebracht wird.
So kann das ganze Bauteil 1 mit der Maskierung 7 in den Beschichtungsprozess eingeführt werden ohne dass eine Beschichtung in dem Bereich 10 erfolgt, in dem keine Beschichtung erwünscht ist, sondern nur in den gewünschten Bereichen auf einer Innenfläche 31 des Bauteils 1. Ebenso kann die Innenfläche 31 durch eine Maskierung teilweise geschützt werden.
Dies ist z.B. bei der Innenalitierung von Turbinenschaufeln für eine Gasturbine besonders sinnvoll.

## Patentansprüche

1. Verfahren zur Beschichtung einer Oberfläche eines Bauteils,
insbesondere einer Turbinenschaufel,
das zumindest folgende Schritte umfasst:
- Aufbringung einer Maskierung auf bestimmte Bereiche der Oberfläche des Bauteils, die keine Beschichtung aufweisen sollen,
- Beschichtung des Bauteils,
**dadurch gekennzeichnet, dass**
die Maskierung (7) zumindest teilweise aus einem Keramikpulver besteht.

2. Verfahren nach Anspruch 1,
**dadurch gekennzeichnet, dass**
die Maskierung (7) aus einer Suspension mit dem Keramikpulver gebildet ist.

3. Verfahren nach Anspruch 1,
**dadurch gekennzeichnet, dass**
die Maskierung (7) aus einer Paste mit einem Keramikpulver gebildet ist.

4. Verfahren nach Anspruch 1,
**dadurch gekennzeichnet, dass**
das Keramikpulver zumindest teilweise ein Zirkonoxidpulver ist.

5. Verfahren nach Anspruch 1,
**dadurch gekennzeichnet, dass**
auf das Bauteil (1) eine Aluminiumschicht aufgebracht wird.

6. Verfahren nach Anspruch 1,
**dadurch gekennzeichnet, dass**
die Beschichtung durch einen Chemical-vapour-deposition - (CVD-) Prozess erfolgt.

## Geänderte Patentansprüche

### Geänderte Patentansprüche gemäss Regel 86(2) EPÜ.

**1.** Verfahren zur Beschichtung einer Oberfläche eines Bauteils,
insbesondere einer Turbinenschaufel,
das zumindest folgende Schritte umfasst:
- Aufbringung einer Maskierung auf bestimmte Bereiche der Oberfläche des Bauteils, die keine Beschichtung aufweisen sollen,
- Beschichtung des Bauteils,
**dadurch gekennzeichnet, dass**
die Maskierung (7) als Schicht aus einem Keramikpulver besteht, wobei zur Herstellung die Maskierungsschicht kein Binder verwendet wird.
